Europäisches Patentamt

European Patent Office

Office européen des brevets

(11) Publication number: **0 323 003**
**A2**

# EUROPEAN PATENT APPLICATION

(21) Application number: 88308478.2

(22) Date of filing: 14.09.88

(51) Int. Cl.4: **H01L 39/12 , H01L 39/24**

(30) Priority: 23.12.87 GB 8730062

(43) Date of publication of application:
05.07.89 Bulletin 89/27

(84) Designated Contracting States:
DE FR GB IT NL

(71) Applicant: **PLESSEY OVERSEAS LIMITED**
**Vicarage Lane**
**Ilford Essex IGl 4AQ(GB)**

(72) Inventor: **Dorey, Lynn Yvette**
**36 Annesley Close**
**Langlands Northampton, NN3 3HD(GB)**
Inventor: **Wort, Christopher John**
**1 Valley End Pattishall**
**Towcester Northants NN12 8NY(GB)**

(74) Representative: **Lupton, Frederick**
**The Plessey Company plc Intellectual**
**Property Dept. Vicarage Lane**
**Ilford, Essex IG1 4AQ(GB)**

(54) **Superconducting thin films.**

(57) The invention relates to a method of protecting thin films of $Y_1Ba_2Cu_3O_{7-\delta}$ films from premature aging (resulting in a deterioration of superconducting properties) on atmospheric exposure, by applying a layer of silver which is impervious to water vapour but pervious to oxygen.

EP 0 323 003 A2

## SUPERCONDUCTING THIN FILMS

The present invention relates to a method of protecting a superconducting thin film from the harmful effects of the atmosphere.

High transition temperature superconductors, such as $Y_1Ba_2Cu_3O_{7-\delta}$, degrade on exposure to the atmosphere and, in particular, to water vapour, resulting in a deterioration of superconducting properties. The problem is more severe in the case of thin $Y_1Ba_2Cu_3O_{7-\delta}$ films where the surface area to volume ratio is much larger than in the case of bulk ceramics. The sensitivity of the as-deposited film (particularly if it is not crystalline or has the incorrect oxygen content) necessitates very careful handling procedures to avoid any exposure to the atmosphere. This is typically achieved by removing the deposited film from the deposition apparatus whilst at a temperature above 100°C, and placing in a dessicator (either evacuated or containing an inert atmosphere such as dry $N_2$ or Ar) prior to film processing or subsequent annealling.

A post-deposition anneal in oxygen of the as-deposited film is necessary to achieve the correct crystallinity and oxygen content, after which the films become more stable with decomposition occuring in days rather than minutes.

A plastics epoxy encapsulant has been investigated but can only be applied after the post-deposition anneal, and though it considerably slows degradation, it does not eliminate it.

In order to overcome the above noted problems, the present invention provides a method of protecting a thin film of superconducting ceramics material, comprising depositing the film on a substrate in deposition apparatus and, prior to removing the film from the deposition apparatus or exposing the film to the atmosphere, applying a layer of material on the deposited film which is impervious to water vapour.

In a more specific aspect, the invention provides a method of protecting a thin film of superconducting ceramics material, the material containing oxygen or another element selected from period 2 of the periodic table, comprising depositing the film on a substrate in deposition apparatus and, prior to removing the film from the deposition apparatus or exposing the film to the atmosphere, applying a layer of material on the deposited film which is impervious to water but pervious to oxygen.

The present invention in a preferred form deposits a continuous then coating ($\leq$1000 Å) of metallic silver onto the $Y_1Ba_2Cu_3O_{7-\delta}$ film whilst it is still under the evacuated deposition conditions, and prior to the post-deposition anneal. The major advantages are:

1) The silver coating protects the $Y_1Ba_2Cu_3O_{7-\delta}$ thin film from atmospheric exposure and subsequent deterioration in superconducting properties.

2) The silver coating allows the diffusion of oxygen into, or out of, the $Y_1Ba_2Cu_3O_{7-\delta}$ during subsequent annealling (should it be required) to obtain the correct crystal structure and oxygen content.

3) The silver allows a good electrical contact to the $Y_1Ba_2Cu_3O_{7-\delta}$ superconducting thin film and any external circuitry.

4) Silver does not react with the $Y_1Ba_2Cu_3O_{7-\delta}$ thin film unlike other contact materials (such as Pt and Al)

A preferred embodiment of the invention will now be described with reference to the accompanying drawings, wherein:-

Figure 1 is a diagram of the thin film geometry for protecting a layer of $Y_1Ba_2Cu_3O_{7-\delta}$;

Figure 2 is a schematic view of apparatus for carrying out the method of the present invention.

A thin film of $Y_1Ba_2Cu_3O_{7-\delta}$ (2) of thickness b is deposited onto a substrate (1) in an evacuated chamber by a low pressure physical deposition technique (i.e. RF or DC magnetron sputtering, e-beam evaporation, molecular beam epitaxy or ion beam sputtering). After the deposition of $Y_1Ba_2Cu_3O_{7-\delta}$ and whilst still under vacuum, a film of silver (3) of thickness c is deposited onto the $Y_1Ba_2Cu_3O_{7-\delta}$ thin film, by a suitable technique (normally sputtering or evaporation). The thin film of $Y_1Ba_2Cu_3O_{7-\delta}$ can then be removed from the -uum chamber prior to film processing or subsequent annealling. In the preferred embodiment the silver film would be deposited by ion beam sputtering to provide better film coverage. Typical deposition conditions are given in Table 1.

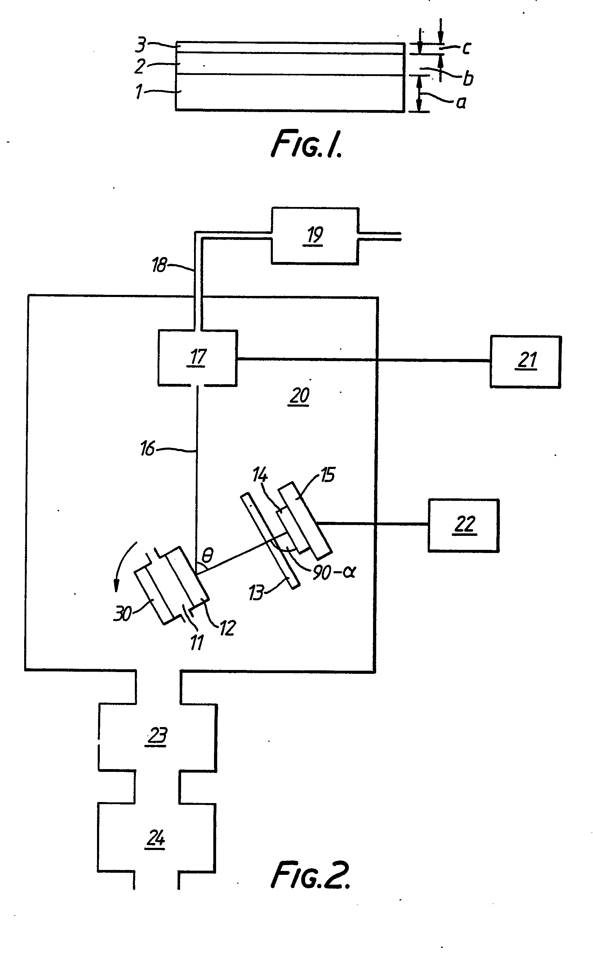

A diagram of the deposition apparatus is shown in Figure 2 and used to give the following detailed description of the formation of $Y_1Ba_2Cu_3O_{7-\delta}$ thin films from a target of composition $Y_1Ba_2Cu_3O_{7-\delta}$. A $Y_1Ba_2Cu_3O_{7-\delta}$ ceramic (12), mounted on a water cooled base (11), is positioned so that an ion beam (16) from an ion gun (17) impinges the target (12) centrally and at an angle $\theta$ to the target normal. A substrate (14) is mounted on a substrate heater (15) and positioned a distance d from the target (12) at an angle $\alpha$ to

2

it, such that the correct geometry is achieved for the material sputtered from the target by the ion beam to impinge on the substrate (14). A deposition chamber (20) is evacuated by a diffusion pump (23) backed by a rotary pump (24). Argon (18) controlled by a mass flow control system (19) is introduced into the chamber at the required pressure through the ion gun (17). A shutter (13) is placed across the substrate (14) to allow precleaning of the target (12) by the ion beam (16). The substrate (14) is adjusted to the required deposition temperature by heater (15) and control electronics (22). The shutter (13) is removed and deposition of $Y_1Ba_2Cu_3O_{7-\delta}$ commences onto the substrate (14). The shutter (13) is replaced over the substrate (14) at the end of the deposition. Base (11) is rectangular in configuration and is rotatable so that a further target (30) of silver may be moved into the position vacated by target (12). A similar procedure to that described above may then be employed to deposit a layer of silver on the superconducting film.

Table 1

| Typical Deposition Conditions | |
|---|---|
| Deposition geometry | $\theta$ = 65 - 80$^\circ$ |
| | $\alpha$ = O$^\circ$ |
| | d = 50 - 150 mm |
| Deposition Pressure | $1.10^{-4}$ - $4.10^{-4}$ torr |
| Ion Current | 20 - 100 mA |
| Ion voltage | 80 - 1800 V |
| Sputtering gas | Argon |

## Claims

1. A method of protecting a thin film of superconducting ceramics material, comprising depositing the film on a substrate in deposition apparatus and, prior to removing the film from the deposition apparatus or exposing the film to the atmosphere, applying a layer of material on the deposited film which is impervious to water vapour.

2. A method of protecting a thin film of superconducting ceramics material, containing oxygen or another element selected from period 2 of the periodic table, comprising depositing the film on a substrate in deposition apparatus and, prior to removing the film from the deposition apparatus or exposing the film to the atmosphere, applying a layer of material on the deposited film which is impervious to water but pervious to oxygen.

3 A method as claimed in claim 1 or 2 wherein the layer makes good electrical contact with the film.

4. A method as claimed in claim 3 wherein the layer is silver.

5. A method as claimed in any preceding claim, wherein both the film and layer are deposited by a technique of evaporation or sputtering from targets of the respective materials.

6. A method as claimed in claim 5, wherein said technique comprises ion beam sputtering.

7 A method as claimed in any preceding claim wherein said ceramic material has the composition $A_a B_b Cu_c D_d$, where A is any rare earth, B is an element selected from group IIa of the periodic table, and D is an element selected form period 2 of the periodic table.

8. A method as claimed in claim 7, wherein A is yttrium, erbium, holmium, dysprosium or lanthanum and/or B is barium, calcium or strontium, and/or D is oxygen, nitrogen or fluorine.

9. A method as claimed in claim 8, wherein the material is yttrium barium copper oxide.

10. A method as claimed in claim 9 wherein the material has the stoichiometric composition $Y_1Ba_2Cu_3O_{7-\delta}$.

11. A method as claimed in any preceding claim wherein the film is subsequently subjected to an annealing process.

12. A method of protecting a superconducting thin film substantially as described with reference to the accompanying drawings.

13. A superconducting thin film produced by a method according to any preceding claim.

14 An electrical component or integrated circuit including a film according to claim 13.

15. Apparatus for carrying out the method according to claim 1, wherein the apparatus comprises an evacuable chamber, a first target of superconducting material, a second target for forming a protection layer on superconducting material which is impervious to water vapour, and means for sputtering or evaporating material from the first and second targets onto a substrate sequentially.

FIG.1.

FIG.2.